Europäisches Patentamt

European Patent Office

Office européen des brevets

(19)

(11) EP 0 936 620 A1

(12) EUROPEAN PATENT APPLICATION

(43) Date of publication:
18.08.1999 Bulletin 1999/33

(51) Int. Cl.⁶: **G11C 7/00**, G11C 16/06

(21) Application number: 98830065.3

(22) Date of filing: 13.02.1998

(84) Designated Contracting States:
AT BE CH DE DK ES FI FR GB GR IE IT LI LU MC NL PT SE
Designated Extension States:
AL LT LV MK RO SI

(71) Applicant:
STMicroelectronics S.r.l.
20041 Agrate Brianza (Milano) (IT)

(72) Inventors:
• Demange, Nicolas
57160 Lessy (FR)
• Gaibotti, Maurizio
20031 Cesano Maderno (MI) (IT)

(74) Representative:
Dini, Roberto, Dr. Ing.
Via Castagnole, 59
10060 None (Torino) (IT)

(54) **Bit line polarisation system for extended supply range non volatile memory sense amplifier**

(57) Biasing system of a bitline in a sense circuit for a non-volatile wide supply voltage range memory, in particular an EEPROM type memory, comprising an amplifier with two inputs to which two current sensing branches are connected, one current being relative to the memory cell and the other one taken from a reference circuit, of the type using a transistor for defining a biasing voltage onto a bitline, said transistor being biased through a voltage obtained by means of a feedback circuit connected to the relevant bitline. According to the invention, in order to supply the said biasing voltage (VBL), said transistor (N1) is in turn biased by a voltage (VGN1), which is in turn obtained through a circuit wherein a stable current (IP) flows, independent from the supply voltage (VDD) value, so that said biasing voltage (VBL) is independent from the supply voltage (VDD) value.

Fig. 2

**Description**

The present invention refers to a sense amplifier circuit for low-voltage non-volatile memories, in particular EEPROM memories.

In the following, reference is made to conventional terms of the MOS (Metal Oxide Semiconductor) transistor technology. In particular the word 'gate' indicates the control electrode, or control gate, of the MOS transistor, while the word 'drain' indicates the load or output electrode and the word 'source' the source or output electrode.

With 'non-volatile' memories the memories are meant, which do not lose the stored data when the circuit supply is off, memories of this kind are the ROM (Read Only Memory), the EPROM (Erasable Programmable Read Only Memory), the EEPROM (Electrically Erasable Programmable Read Only Memory) and the EAROM (Electrically Alterable Read Only Memory).

In the EEPROM, in particular, the data to be memorized is stored substantially by means of a MOS transistor. Said MOS transistor comprises two crate electrodes, one being a control gate, electrically connected to the circuit and which receives the gate voltage, the other being a so called floating gate, separated from the control gate by means of an SiO$_2$ oxide barrier, into which it is buried.

Depending on the logic state to be memorized, by means of the application of appropriate voltages, a positive or negative charge is trapped inside the floating gate. In fact said charge is transferred by tunnel effect from the substrate to the floating gate, through the potential barrier built by the oxide layer, and trapped therein. The trapped charge acts on the voltage-current relationship of the transistor, so that a change of the threshold voltage of the transistor takes place, according to the type of the trapped charge inside the floating gate. The memory cell formed by the MOS transistor may assume three different status, i.e. written, erased or virgin status, depending on the fact that the charge inside the floating gate is of one or the other type, or a charge has never been there.

The correlation between the logic state, the sign of the trapped charge and the cell status, written or erased, is a matter of choice and may change from a product to another according to the selected convention.

The logic state of a cell can be identified sensing the current flowing through it in known bias conditions. In fact, if a negative charge is trapped inside the floating gate, the transistor threshold is higher in respect of that of a virgin transistor, therefore with the same gate-source voltage a smaller current will flow. Viceversa, if a positive charge is trapped inside the floating gate, the threshold voltage is lower in respect of that of a virgin transistor, and the current is greater.

In fact, the detection of the logic state is made comparing the current of a cell to the current of a virgin cell in the same biasing conditions. The comparison is made by means of a so called "sense amplifier".

As will be explained later, this operation is rather sensitive to the level of the supply voltage VDD; it is therefore difficult to realize a sense amplifier which can work in a wide range of supply voltages (e. g. from 2 to 7V) with a controlled and reliable behaviour.

The known sense amplifiers are often based on a current mirror arranged between two input branches of an amplifying circuit.

The drain electrodes, organized as an array, are connected to a "bitline", and a decoder selects one of the cells; a sense circuit is connected to the bitline of the selected cell; another identical circuit is connected to a virgin cell, arranged outside of the array and conventionally called bitline too, due to the high symmetry of the circuit, even if it is really connected to a cell which does not represent any logic state, but a reference signal.

The virgin cell current (in the following called reference current) is mirrored through the current mirror circuit into the branch of the sense amplifier connected to the selected cell. Each one of the branches supplies a voltage at the output, the two voltages being compared by means of an operational amplifier.

Hence, for sensing the selected cell current, a fixed voltage is applied to the cell drain, that is to the bitline. This voltage shall be well controlled in order to work with a fixed point of the cell characteristic, and shall be on one hand the lowest possible in order not to stress the drain, and on the other hand high enough in order to keep the cell conducting. Typically the voltage is comprised between 0.5 and 1 V.

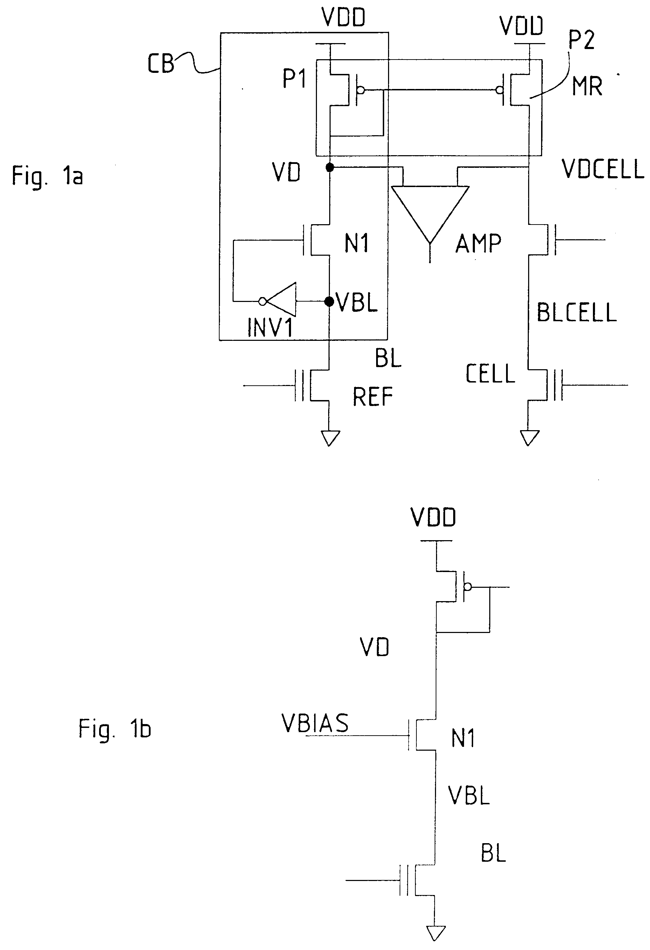

In fig. 1a there is represented a sense amplifier circuit with a known biasing circuit CB.

The biasing circuit CB, in order to create said fixed voltage, is basically constituted by a transistor N1, the control electrode, or gate, thereof being controlled by an inverter INV1, the input of which is connected to a bitline BL. Said inverter INV1 is realized with the CMOS technology, and comprises a P-channel transistor, called "pull-up" transistor, and an N-channel transistor, called "pull-down" transistor. Said bitline BL is therefore the bitline relating to the reference cell REF. In fig. 1a there are also shown, for the sake of completeness, an amplifier AMP and a current mirror MR, apt to obtain the comparison between the current flowing in the bitline BL and the current flowing in a bitline BLCELL, to which a cell CELL is connected, the information of which has to be sensed. Current mirror MR utilizes the same transistor P1 which acts also as the load for the biasing circuit CB. Said biasing circuit CB defines so a determined voltage VBL on the bitline BL, i. e. on the drain of the cell REF. Said voltage VBL shall be high enough to keep a sufficient drain-source voltage VDS to the cell to be read. Voltage VBL depends on the inversion voltage Vinv of the inverter INV1 and on the threshold voltage VTN1 of transistor N1. The biasing circuit CB is completed by a load, in the figure a P-channel transistor P1, connecting the drain of transistor N1 to the supply voltage VDD. The voltage VBL is fixed and the voltage VD on the drain of the transistor N1 will change according to the current flowing in the cell (and in the transistor N1).

The circuit of figure 1a makes the voltage VBL dependent on the value of the supply voltage VDD. The inverter INV1 is used in an analog manner, that is exploiting its voltage-current characteristic in order to establish a voltage on the bitline BL, through the dynamic balance which is reached in the feedback loop made together with the transistor N1. Hence, on the contrary of the "logic" way of operation, inverter INV1 is exploited in that region of the voltage-current characteristic curve where both the transistors are conducting. Said region, as known, is located in proximity of the inversion voltage Vinv. Voltage VBL depends on the inversion voltage Vinv of inverter INV1, which, in turn, is a function of the supply voltage VDD, according to the known equation:

$$Vinv = \frac{\sqrt{\beta_p}}{\sqrt{\beta_p}+\sqrt{\beta_n}} VDD + \frac{\sqrt{\beta_p}Vtp + \sqrt{\beta_n}Vtn}{\sqrt{\beta_p}+\sqrt{\beta_n}} \qquad (1)$$

where $\beta_n$ and $\beta_p$ are the gains of N and P transistors, $V_{tn}$ and $V_{tp}$ the respective threshold voltages.

This fact creates problems if it is desired to operate in a wide range of supply voltages. Moreover, with very low supply voltages (1.8 V or less), according to the used technology, the behaviour of the P-channel transistor of inverter INV1 causes a loss of control of the inversion voltage Vinv. It may therefore happen that the N-channel transistor and the P-channel transistor are not conducting contemporarily. Low temperatures further worsen the situation because the threshold voltage becomes greater.

When the bitline BL is discharged and must then be charged, the circuit of fig. 1a allows a quick recharging because the 'gate' of the transistor N1 is at supply voltage VDD, and the bitline BL, which is connected to the input of inverter INV1 is at 0 logic level; as a consequence said gate of transistor N1 is forced towards a lower voltage by the inverter INV1 until the final biasing voltage has been reached.

Another way to fix the voltage value of VBL is shown in fig. 1b; the voltage VBL is charged through the transistor N1, biased at a fixed voltage VBIAS, externally forced. In this case we have VBL=VBIAS-VTN1. Of course the fixed voltage VBIAS must be well controlled, with the disadvantage, for instance, that a special circuit must be provided to this purpose.

The present invention has the aim of fixing the above cited problems and of indicating a biasing system of a bitline for a memory sense amplifier which is independent from the supply voltage. In order to reach the above indicated aims, the present invention is directed to a biasing system of a bitline for a memory sense amplifier circuit having the characteristics indicated in the attached claims, which are integral part of the present description.

Further aims, characteristics and advantages of the present invention will be clear from the following detailed description and from the attached drawings, given only as an explicatory non-limiting example, wherein:

- figure 1a shows a known biasing system of a bitline;
- figure 1b shows a second known biasing system of a bitline;
- figure 2 shows a biasing system of a bitline according to the present invention.

In the attached figure 1a there schematically represented a first known biasing system of a bitline as already described above.

In the attached figure 1b there schematically represented a second known biasing system of a bitline as already described above.

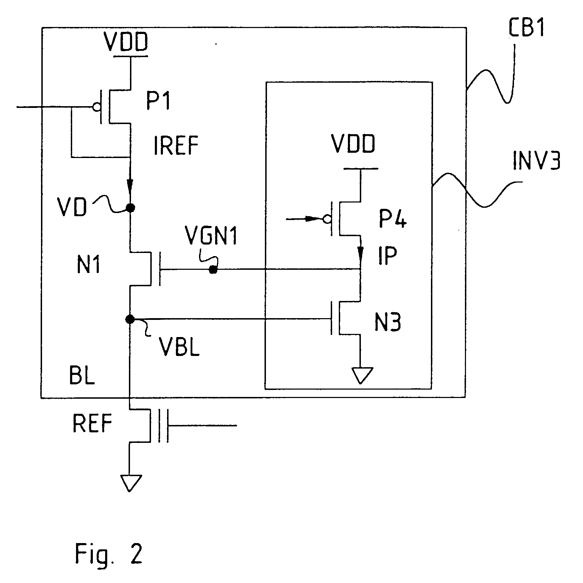

The invention consists in replacing the inverter INV1 of the biasing circuit CB of fig 1a with a circuit INV3, which is insensitive to the variation of the supply voltage VDD, inserted in a biasing circuit CB1, as shown in fig 2.

As can be seen, the N-channel transistor N3 of the circuit INV3 is connected to the bitline BL, as the inverter INV1 of fig. 1a, but the P-channel transistor P4 instead is not connected to the bitline BL, and operates according to the principle of a current mirror. The transistor P4 in fact mirrors a stable current IP, generated outside by means of a not shown current generator, and injected to control the gate of the said transistor P4. This can be made, for instance, by means of a real current mirror circuit, of which the transistor P4 is the part which mirrors the IP current, forced into another transistor, connected to it through the gate.

The value of said stable current IP is selected to the only purpose of maintaining saturated the transistor P4. In this way the voltage VGN1 at the gate of transistor N1, and therefore the voltage VBL, determined by it, are independent from the supply voltage VDD and depend instead on the stable current IP, which can be set according to the circuit needs.

From the given description the characteristics of the present invention will result clear, as well as the relevant advantages.

According to the invention the use of an inverter is then avoided, having a behaviour strongly dependent from the value of the supply voltage VDD. The biasing system of a bitline according to the invention operates therefore in a wide range of values of the supply voltage, because the bias of transistor N1, operating as a current-voltage converter, is made independent from the supply voltage.

The described circuit can be conveniently used in EEPROM memories of the 1Mb parallel type, assuring a 100 ns access time at 2.7 V and a 200 ns access time at 1.8 V besides the possibilty of operation up to 7 V without modifications.

From the given description and the attached drawings the advantages of the biasing system of a bitline according to the invention will result clear; it is also clear that many variations to the circuit described as an example are possible without leaving the novelty principles of the invention.

## Claims

1.  Biasing system of a bitline in a sense circuit for a non-volatile wide supply voltage range memory, in particular an EEPROM type memory, comprising an amplifier with two inputs to which two current sensing branches are connected, one current being relative to the memory cell and the other one taken from a reference circuit, of the type using a transistor for defining a biasing voltage onto a bitline, said transistor being biased through a voltage obtained by means of a feedback circuit connected to the relevant bitline, characterized in that in order to supply the said biasing voltage (VBL), said transistor (N1) is in turn biased by a voltage (VGN1), which is in turn obtained through a circuit wherein a stable current (IP) flows, independent from the supply voltage (VDD) value, so that said biasing voltage (VBL) is independent from the supply voltage (VDD) value.

2.  Biasing system of a bitline in a sense circuit for a non-volatile wide supply voltage range memory, according to claim 1, characterized in that the gate of said transistor (N1) is connected to an inverter (INV3).

3.  Biasing system of a bitline in a sense circuit for a non-volatile wide supply voltage range memory, according to claim 2, characterized in that said inverter (INV3) comprises two transistors wherein the first transistor (N3) has the gate connected to the bitline (BL), while the second transistor (P4) has the gate connected to an external source delivering the stable current (IP).

4.  Biasing system of a bitline in a sense circuit for a non-volatile wide supply voltage range memory, according to claim 3, characterized in that the second transistor (P4) is a part of a current mirror which delivers said stable current (IP).

Fig. 1a

Fig. 1b

Fig. 2

European Patent Office

## EUROPEAN SEARCH REPORT

Application Number

EP 98 83 0065

### DOCUMENTS CONSIDERED TO BE RELEVANT

| Category | Citation of document with indication, where appropriate, of relevant passages | Relevant to claim | CLASSIFICATION OF THE APPLICATION (Int.Cl.6) |
|---|---|---|---|
| X | EP 0 477 369 A (TOKYO SHIBAURA ELECTRIC CO ;TOSHIBA MICRO ELECTRONICS (JP)) 1 April 1992 | 1-3 | G11C7/00 G11C16/06 |
| Y | * column 37, line 7 - column 39, line 24; figures 16-24 * --- | 4 | |
| Y | US 5 502 406 A (TRAYNOR KEVIN M ET AL) 26 March 1996 * column 2, line 6 - line 14; figure 2 * --- | 4 | |
| A | US 5 528 543 A (STIEGLER HARVEY J) 18 June 1996 * column 4, line 28 - line 45; figure 2 * ----- | 1-3 | |
| | | | TECHNICAL FIELDS SEARCHED (Int.Cl.6) G11C H03K |

The present search report has been drawn up for all claims

| Place of search | Date of completion of the search | Examiner |
|---|---|---|
| THE HAGUE | 8 July 1998 | Cummings, A |

EPO FORM 1503 03.82 (P04C01)